(19)

Europäisches Patentamt
European Patent Office
Office européen des brevets

(11) **EP 3 591 685 A1**

(12) **EUROPEAN PATENT APPLICATION**

(43) Date of publication:
**08.01.2020 Bulletin 2020/02**

(51) Int Cl.:
*H01J 37/09* (2006.01)     *H01J 37/26* (2006.01)

(21) Application number: **18182145.5**

(22) Date of filing: **06.07.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **FEI Company**
**Hillsboro, OR 97124-5793 (US)**

(72) Inventors:
• **Henstra, Alexander**
  **3544 PW Utrecht (NL)**
• **Dona, Pleun**
  **5504 KN Veldhoven (NL)**

(74) Representative: **Janssen, Francis-Paul**
**FEI Company**
**Patent Department**
**P.O.Box 1745**
**5602 BS Eindhoven (NL)**

(54) **ELECTRON MICROSCOPE WITH IMPROVED IMAGING RESOLUTION**

(57)     An Electron Microscope M comprising:
- A specimen holder H, for holding a specimen S;
- A source 4, for producing a beam B of electrons;
- An illumination system 6, for directing said beam so as to irradiate the specimen;
- An elongate beam conduit B", through which the beam is directed;
- A detector 26, 30, 32, 34, for detecting radiation emanating from the specimen in response to said irradiation,
wherein at least a longitudinal portion of said beam conduit has a composite structure comprising:
- An outer tube 50 of electrically insulating material;
- An inner skin 52 of electrically conductive material.

    In an alternative but related structure, at least a longitudinal portion of said beam conduit is comprised of an aggregate composite material comprising intermixed electrically insulating material and electrically conductive material.

Fig. 1

**(Cont. next page)**

EP 3 591 685 A1

Fig. 2A

Fig. 2B

**Description**

The invention relates to an Electron Microscope comprising:

- A specimen holder, for holding a specimen;
- A source, for producing a beam of electrons;
- An illumination system, for directing said beam so as to irradiate the specimen;
- An elongate beam conduit, through which the beam is directed;
- A detector, for detecting radiation emanating from the specimen in response to said irradiation.

The invention also relates to a method of using such an Electron Microscope.
Electron microscopy is a well-known and increasingly important technique for imaging microscopic objects. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" apparatus (*e.g.* a FIB-SEM), which additionally employ a "machining" Focused Ion Beam (FIB), allowing supportive activities such as ion-beam milling or Ion-Beam-Induced Deposition (IBID), for example. More specifically:

- In a SEM, irradiation of a specimen by a scanning electron beam precipitates emanation of "auxiliary" radiation from the specimen, in the form of secondary electrons, backscattered electrons, X-rays and cathodoluminescence (infrared, visible and/or ultraviolet photons), for example; one or more components of this emanating radiation is/are then detected and used for image accumulation purposes.
- In a TEM, the electron beam used to irradiate the specimen is chosen to be of a high-enough energy to penetrate the specimen (which, to this end, will generally be thinner than in the case of a SEM specimen); the transmitted electrons emanating from the specimen can then be used to create an image. When such a TEM is operated in scanning mode (thus becoming a STEM), the image in question will be accumulated during a scanning motion of the irradiating electron beam.
- A SEM can also be used in "transmission mode", *e.g.* when using relatively thin samples and a relatively high incident beam energy. Such a tool is often called a "TSEM" (Transmission SEM), and it will typically have a relatively rudimentary imaging system (*e.g.* a single lens and deflector) disposed between the specimen and post-specimen detector.

It should be noted that, in addition to imaging and performing (localized) surface modification (*e.g.* milling, etching, deposition, *etc.*), an Electron Microscope may also have other functionalities, such as performing spectroscopy, examining diffractograms, *etc.*
In all cases, an Electron Microscope (EM) will comprise at least the following components:

- An electron source, such as a W or LaB$_6$ source, Schottky gun or Cold Field Emission Gun (CFEG), for instance.
- An illumination system / illuminator, which serves to manipulate a "raw" radiation beam from the source and perform upon it certain operations such as focusing, aberration mitigation, cropping (with a diaphragm), filtering, *etc.* It will generally comprise one or more (charged-particle) lenses, and may comprise other types of (particle-)optical component also. If desired, the illuminator can be provided with a deflector system that can be invoked to cause its exit beam to perform a scanning motion across the specimen being investigated.
- A specimen holder - generally connected to a positioning system - on which a specimen under investigation can be held and positioned (*e.g.* displaced, tilted, rotated). If desired, this holder can be moved so as to effect scanning motion of the specimen w.r.t. the beam. When designed to hold cryogenic specimens, the specimen holder can comprise means for maintaining said specimen at cryogenic temperatures, e.g. using an appropriately connected cryogen vat.
- A detector (for detecting radiation emanating from an irradiated specimen), which may be unitary or compound/distributed in nature, and which can take many different forms, depending on the radiation being detected. Examples include photodiodes, CMOS detectors, CCD detectors, photovoltaic cells, X-ray detectors (such as Silicon Drift Detectors and Si(Li) detectors), *etc.* In general, an EM may comprise several different types of detector, selections of which can be invoked in different situations.

In the case of a transmission-type microscope (such as a (S)TEM or TSEM, for example), an EM will additionally comprise:

- An imaging system, which essentially takes electrons that are transmitted through a specimen (plane) and directs (focuses) them onto analysis apparatus, such as a detector, imaging device, spectroscopic apparatus (such as an EELS device: EELS = Electron Energy-Loss Spectroscopy), *etc.* As with the illuminator referred to above, the imaging system may also perform other functions, such as aberration mitigation, cropping, filtering, *etc.,* and it will generally comprise one or more charged-particle lenses and/or other types of particle-optical components.

Over significant portions of its trajectory through the microscope, the beam will propagate through an elongate (cylindrical) beam conduit, which creates a relatively small-volume evacuated enclosure proximal to the optical axis (of the illuminator, and imaging system when present).

Although there is a constant desire - from within various technological fields - to further improve the imaging resolution that can be obtained with EMs, this task is far from trivial. State-of-the-art EMs already employ aberration correctors (typically comprising groups of multipole (*e.g.* quadrupole, hexapole and/or octupole) lens elements) to mitigate imaging aberrations such as astigmatism, chromatic aberration and spherical aberration, which can contribute significantly to image degradation. However, despite such elaborate measures, EM imaging quality is still generally adversely affected by a variety of physical effects, including higher-order aberrations, Coulomb interactions, vacuum level fluctuations, and stray fields, for example. One such impediment that was recently discovered is electron beam disturbance due to "parasitic" thermal magnetic field noise along the beam path, as described by S. Uhlemann et al. in Physical Review Letters [PRL] 111, pp. 046101-046105, July 26, 2013 (American Physical Society), in which the authors demonstrate a thermodynamic character of the observed magnetic field noise in a TEM, and take measures to cool "conductive parts of the instrument" to cryogenic temperatures (e.g. ~77 K) in an attempt to curtail this phenomenon. Because the magnitude of the phenomenon scales with temperature, the intimation is that cooling to liquid helium temperatures will be required in order to achieve ultimate minimization of these noise effects.

It is an object of the invention to address these issues in an alternative way. More specifically, it is an object of the invention to provide an EM design in which such magnetic field noise effects are addressed without having to rely on the abovementioned elaborate cooling measures.

In a first approach, these and other objects are achieved in an Electron Microscope as set forth in the opening paragraph above, characterized in that at least a longitudinal portion of said beam conduit has a composite structure comprising:

- An outer tube of electrically insulating material;
- An inner skin of electrically conductive material.

The inventors consider a solution that requires cryogenic cooling of "conductive parts of" an EM (such as the iron cores/yokes in magnetic lenses, the beam conduit, *etc.*) to be highly burdensome. The particle-optical column of an EM is already a tightly packed space in which relatively bulky, ultra-high-precision sub-components are positioned in close proximity to one another within tight tolerances, leaving very little room to spare. It would be an onerous undertaking to try to make additional space in such a set-up for the relatively cumbrous cooling elements / coils / supply lines that would be required to cool large parts of the microscope to cryogenic temperatures. The present invention therefore takes a radically different approach. Realizing the parasitic magnetic fields referred to above to be largely attributable to Johnson-Nyquist currents in the walls of the beam conduit - which traditionally consists of a metallic (*e.g.* stainless steel or titanium) pipe - the inventors decided to replace conventional beam conduit designs by an electrically insulating tube, *e.g.* comprising a durable ceramic such as Zirconia ($ZrO_2$) or Alumina ($Al_2O_3$). To prevent space charging of such a tube, its inner surface is covered by a (grounded) skin of electrically conductive material, such as a metallic film - which should be relatively thin / resistive, so that it itself does not become a significant harbor/source for parasitic currents. A construction such as this seems to be disqualified by the abovementioned PRL journal article, which makes an argument that, by reducing conductivity and metallic wall thickness, the noise spectrum may be shifted somewhat from lower to higher frequencies, but the total noise power remains essentially the same, resulting in a negligible/marginal net effect on image spread. However, the present inventors have shown that this argument is flawed: if the abovementioned spectral shift is large enough, then peak spectral power can be diverted into a frequency domain where Johnson-Nyquist fields no longer significantly affect the electron beam. More specifically, frequencies higher than the microwave cut-off frequency of the inventive beam conduit do not make a substantial contribution to image spread / blurring.

On the basis of the discussion above, the skilled artisan will understand that the inner skin of the inventive composite beam conduit should (simultaneously) be:

- Thick/conductive enough to effectively remove space charge (induced surficial charge, e.g. caused by (spurious) electron impact);
- Thin/resistive enough to avoid being a significant harbor for parasitic currents itself.

In this regard, the product $\sigma t$ of skin (electrical) conductivity $\sigma$ and skin thickness t can play an indicative role, and there tends to be a general preference for relatively small values of $\sigma t$. For example, and to offer some guidance, in a (S)TEM operating at 300 kV, the inventors have found that a value $\sigma t < 0.1$ $\Omega^{-1}$ yields satisfactory results, with better results obtained for $\sigma t < 0.01$ $\Omega^{-1}$, and a further improvement for $\sigma t < 0.001$ $\Omega^{-1}$. A given value of $\sigma t$ can be realized by choosing a variety of different (but complementary) values of $\sigma$ and t individually; however, in practice, the skilled artisan will understand that some practical constraints need to be taken into account. For example:

- A relatively low value of *t* (*e.g.* less than a few nm) may introduce manufacturing complications, *e.g.* as regards choice of deposition technique, non-contiguousness (island forming), *etc.*
- A relatively high value of *t* (*e.g.* greater than the order of about 100 $\mu$m) may severely curtail a list of candidate materials with which an appropriate $\sigma$ value van be achieved.

To offer some guidance, the inventors have achieved good results using *t* in a range of about 5-20 $\mu$m, corresponding to a $\sigma$ value that can be achieved using various relatively common conductive materials. For good order, it should be noted that:

- $\sigma$ = 1/p, where $\rho$ is electrical resistivity;
- $\sigma t = 1/R_s$, where $R_s$ is the sheet resistance of the skin, with $R_s = \rho/t$.

As regards suitable materials for use in the inventive composite beam conduit, the following non-limiting examples are given for guidance purposes:

- The outer tube may, for instance, comprise at least one material selected from the group comprising ceramics, vitreous materials, quartz, and combinations hereof. The term "ceramics" includes engineering ceramics such as the aforementioned Zirconia ($ZrO_2$) and Alumina ($Al_2O_3$). Such materials are generally durable, temperature-resistant (and thus able to withstand a vacuum bake-out), non-problematic as regards outgassing behavior, and relatively easy to make in a tubular shape (*e.g.* using casting). For good order, it is noted that, in conventional EMs, the beam conduit generally has an inner diameter of the order of about 6-8 mm, though this value range is not limiting.
- The inner skin comprises at least one material selected from the group comprising ruthenium oxide, titanium nitrate, and combinations hereof. These materials have convenient values of $\sigma$, and can be relatively easily deposited on the inner surface of the outer tube using processes such as PE-CVD (Plasma-Enhanced Chemical Vapor Deposition), PE-ALD (Plasma-Enhanced Atomic Layer Deposition), and PVD (Physical Layer Deposition), for example. This group is not limiting: in principle, metals such as W, Ti or Pt (or combinations hereof) could also be used in the inner skin, *inter alia* depending on the chosen skin thickness *t.*

For good order, it should be noted that, as referred to in the context of the current invention, the term "electrically insulating material" can also include materials that might traditionally be considered as being semiconductors. For example, SiC is a ceramic material that is conventionally labelled as being a semiconductor; however, its electrical resistivity is $\sim 10^6$ $\Omega$ cm - which makes it about $10^{16}$ times less conductive than aluminum, which has a resistivity of $\sim 10^{-10}$ $\Omega$ cm. By comparison, the electrical resistivities of Quartz, Alumina and Zirconia are $\sim 10^{16}$, $10^{14}$ and $10^9$ $\Omega$ cm, respectively. The skilled person will understand that an electrical insulator is a material in which there is (basically) no free transport of (conduction) electrons, usually due to the presence of a relatively large band gap in such materials.

In a second, related approach, an Electron Microscope according to the invention is characterized in that said beam conduit is comprised of an aggregate composite material comprising intermixed electrically insulating material and electrically conductive material. Such an approach builds upon similar insights to those set forth above, but it does so using a beam conduit architecture in which the "laminate structure" of separate electrically insulating outer tube and electrically insulating inner skin described above are effectively "morphed" into a single "monolithic" aggregate composite structure. The electrical conductivity of this morphed structure is intermediate between that of regular conductive materials and insulating materials, and it can be functionally referred to as a "high-volume-resistivity" material. It is concurrently:

- Insulating enough to mitigate blurring effects of parasitic Johnson-Nyquist currents in the conduit wall; and yet:
- Conductive enough to remove space charge that tends to accumulate on its inner surface.

If one considers:

- The outer tube in the aforementioned laminate structure to have a wall thickness $t_t$, and;
- The beam conduit in the current aggregate structure to have a wall thickness $t_w$,

then one way of appreciating the properties of this morphed structure is to consider it to be an "evolution" of the abovementioned laminate structure in which:

- $t_t$ decreases to 0;
- $t$ increases to $t_w$, so that the previous "skin" becomes a self-supporting wall;
- $\sigma$ concurrently/commensurately decreases.

In this analogy, for a given value of the product $\sigma t$ (see discussion above and below), it is seen that:

- If $t$ is increased (to $t_w$) by a factor of the order of ca. $10^2$ (*e.g.* from *ca.* 10 microns to ca. 1 mm), then;
- $\sigma$ will need to commensurately decrease by the same factor of *ca.* $10^2$, which reduces $\sigma$ to a level that can be regarded as intermediate between regular conductors and insulators.

With regard to the constitution of an aggregate composite structure as set forth in the previous paragraph, suitable examples of component materials include:

- Electrically insulating materials: ceramics, such as SiC and/or ZrO, for instance.
- Electrically conductive materials: graphite and/or TiN, for instance.

One way of achieving such a composite is to intermix conductive material (*e.g.* in the form of particles or fibers) in a matrix of insulating material (*e.g.* in the form of green ceramic material); alternatively, one can start with a conductive material and "temper" its conductivity by intermixing an insulating material therein. The additive in question may, for example, be included in the receptive bulk material using a process such as diffusion or ion implantation, or by physical mixing of granulates, for instance. The skilled artisan will be able to determine the relative quantities of different materials to be mixed in order to achieve an aggregate composite with a given bulk resistivity, and/or he can purchase pre-made products. For example, aggregate composite materials as referred to here are commercially available from firms such as Poco Graphite, Inc., in Decatur, Texas, USA. They are sometimes referred to as "ESD" materials, because of their suitability to mitigate electrostatic discharge issues. Other terms that are sometimes used for such materials include "electro-ceramics" and "granular metals". Materials such as this are, for example, discussed in the journal article "Granular electronic systems" by I.S. Beloborodov et al., Rev. Mod. Phys. 79, pp. 469 (April, 2007): https://journals.aps.org/rmp/abstract/10.1103/RevModPhys.79.469

The inventive composite beam tube construction set forth above (in either approach) does not necessarily have to be employed over the entire length of the (primary) beam path in the microscope (though such full-length deployment is, of course, possible). In practice, the inventors have found that:

- Induced image spread (due to magnetic field noise) at a given location in the beam conduit tends to scale with axial beam diameter at that location, and therefore;
- Some portions of the beam path are more susceptible to magnetic field noise than others, and it is in these portions that the current invention is most useful.

In one possible embodiment:

- The microscope comprises a multipole lens assembly configured as an aberration corrector;
- The inventive composite beam conduit extends at least through this aberration corrector.

Examples of an aberration corrector as referred to here include a spherical aberration (Cs) corrector, a chromatic aberration (Cc) corrector, and a combined spherical-chromatic (Cs-Cc) corrector - which may be employed in SEMs and/or TEMs. For instance:

- In a SEM or STEM, a Cs corrector can be included in the illumination system (prior to the specimen). Such a Cs corrector will often have a length (along the beam path) of the order of *ca.* 15cm.
- In a TEM, a combined Cs-Cc corrector can be included in the imaging system, which is located downstream of the specimen and which serves to direct electrons that are transmitted through the specimen onto an (imaging, diffractogram and/or spectral) detector. Such a Cs-Cs corrector will often have a length (along the beam path) of the order of ca. 45cm, though there are also Cs-Cc correctors up to about twice this length, for instance.

More information on Cs and Cc correctors can, for example, be gleaned from the following references:

- United States Patent US 5,084,622;
- H. Rose and W. Wan, "Aberration correction in electron microscopy", IEEE Proceedings of 2005 Particle Accelerator Conference, Knoxville, Tennessee, USA, pp. 44-48 (2005).

When an aberration corrector as referred to above is employed, another relatively sensitive portion of the beam path in which the present invention can be exploited is a trajectory extending between the specimen plane (specimen holder) and the aberration corrector. By this is meant either or both of:

- A trajectory from corrector to specimen plane (upstream of the specimen plane), *e.g.* in a STEM;
- A trajectory from specimen plane to corrector (downstream of the specimen plane), *e.g.* in a TEM.

Moreover, application of the invention at portions of the beam path that are located in/near electrostatic deflection modules can be advantageous. The skilled artisan will be able to decide which portions of the beam path (most) merit application of the inventive composite beam conduit, and may decide to deploy it along (substantially) the entire primary beam path. This latter scenario is of merit *inter alia* in that it avoids having to make a joint between two different types of beam conduit - bearing in mind that the entire beam conduit must reliably sustain a high vacuum (at least) during operation of the microscope.

Using the present invention, one can achieve excellent STEM image resolution values of, for example, 30 pm at a beam voltage of 300 kV, and 60 pm at a beam voltage of 60 kV, in both cases for a beam half opening angle of 50 mrad, and without having to resort to cumbersome cryogenic cooling as set forth in the abovementioned PRL journal article. With respect to a conventional stainless steel beam conduit, the invention typically allows image spread caused by Johnson-Nyquist noise to be reduced by a factor of the order of about 10-15.

Supplemental to the inventive measures described above, there are additional measures that can be taken to further reduce the detrimental imaging effects of Johnson-Nyquist noise, without necessarily having to resort to the cryogenic cooling described in the aforementioned PRL journal article. One such measure is to widen the bore in one or more magnetic (*e.g.* iron) yokes used to conduct field lines into the direct vicinity of the beam. Nominally, such bores hug / contact the outer surface of the beam conduit, so as to get as close as possible to the beam axis. However, the inventors have noted that, for a cylindrical bore of (inner) radius $r$, the yoke contributes to Johnson-Nyquist blurring according to a $1/r$ dependency; consequently, widening the bore will reduce the effect of such blurring. Increasing the bore size in this manner will cause an empty gap to be created between the inner surface of the bore and the outer surface of the beam conduit, but such a gap does not necessarily have significant (overriding) negative aspects.

The invention will now be elucidated in more detail on the basis of exemplary embodiments and the accompanying schematic drawings (not to scale), in which:

Figure 1 renders a longitudinal cross-sectional elevation view of an embodiment of an EM (in this case, a (S)TEM) in which the present invention is implemented.

Figure 2A shows a magnified transverse cross-sectional view of part of Figure 1.

Figure 2B shows a modified version of the embodiment in Figure 2A.

Figure 3 is a plot of relative image spread (due to magnetic field noise, and compared to a conventional beam conduit) as a function of $\log_{10}$ of $\sigma t$ (skin conductivity x skin thickness) for an embodiment of the present invention as shown in Figure 2A, at different beam voltages.

Figure 4 shows a magnified transverse cross-sectional view of an alternative (but related) embodiment to that shown in Figure 2A/2B.

In the Figures, where pertinent, corresponding parts are indicated using corresponding reference symbols.

Embodiment 1

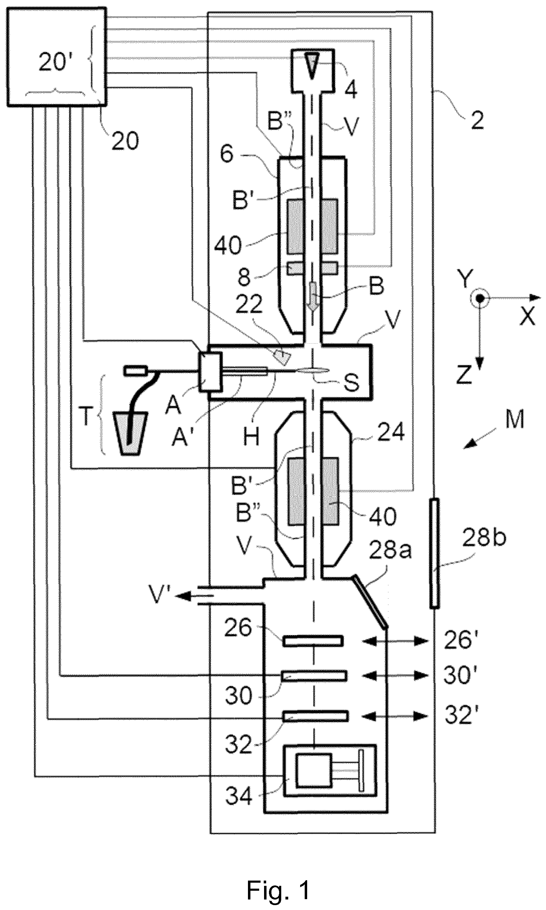

Figure 1 (not to scale) is a highly schematic depiction of an embodiment of an EM M in which the present invention is implemented; more specifically, it shows an embodiment of a TEM/STEM (though, in the context of the current invention, it could just as validly be a SEM, for example). In the Figure, within a general cabinet/cover 2, there is a vacuum enclosure V, which can be evacuated by a schematically depicted vacuum pump assembly V'. Within this vacuum enclosure V, an electron source 4 produces a beam B of electrons that propagates along an electron-optical axis B' and traverses an illuminator system (electron beam column) 6, serving to direct/focus the electrons onto a chosen part of a specimen S (which will generally be (locally) thinned/planarized). Also depicted is a deflector 8, which (*inter alia*) can be used to effect scanning motion of the beam B. Where possible, the vacuum enclosure V will generally "hug" the axis B', taking the form of a relatively narrow elongate beam conduit B" (*e.g.* of the order of ca. 0.5 cm in diameter) through (at least) the illuminator 6, but widening out where necessary to accommodate certain structures (such as the items H, 26, 30, 32, and 34 discussed below, for example).

The specimen S is held on a specimen holder H that can be positioned in multiple degrees of freedom by a positioning device / stage A, which moves a cradle A' into which holder H is (removably) affixed; for example, the specimen holder H may comprise a finger that can be moved (*inter alia*) in the XY plane (see the depicted Cartesian coordinate system), with motion parallel to Z and tilt about X/Y also typically being possible. Such movement allows different parts of the specimen S to be illuminated / imaged / inspected by the electron beam B traveling along axis B' (in the Z direction), and/or allows scanning motion to be performed as an alternative to beam scanning. If (as is often the case) the specimen S is a cryogenic specimen, then the specimen holder H can be maintained at a cryogenic temperature using a (schematically depicted) temperature control assembly T; this may, for example, comprise a thermally conductive (*e.g.* metallic) wick that is thermally connected to the holder H and is immersed in a bath of cryogen, or a pipe system carrying a circulating cryogen, for example.

The electron beam B will interact with the specimen S in such a manner as to cause various types of "stimulated" radiation to emanate from the specimen S, including (for example) secondary electrons, backscattered electrons, X-rays and optical radiation (cathodoluminescence). If desired, one or more of these radiation types can be nominally detected with the aid of analysis device 22, which might be a combined scintillator/photomultiplier or EDX (Energy-Dispersive X-Ray Spectroscopy) module, for instance; in such a case, an image could be constructed using basically the same principle as in a SEM. However, alternatively or supplementally, one can study electrons that traverse (pass through) the specimen S, exit/emanate from it and continue to propagate (substantially, though generally with some deflection/scattering) along axis B'. Such a transmitted electron flux enters an imaging system (projection lens) 24, which will generally comprise a variety of electrostatic / magnetic lenses, deflectors, correctors (such as stigmators), *etc.* In normal (non-scanning) TEM mode, this imaging system 24 can focus the transmitted electron flux onto a fluorescent screen 26, which, if desired, can be retracted/withdrawn (as schematically indicated by arrows 26') so as to get it out of the way of axis B'. An image or diffractogram of (part of) the specimen S will be formed by imaging system 24 on screen 26, and this may be viewed through viewing ports 28a, 28b located in suitable parts of the walls of enclosure V / cabinet 2. The retraction mechanism for screen 26 may, for example, be mechanical and/or electrical in nature, and is not depicted here.

As an alternative to viewing an image/diffractogram on screen 26, one can instead make use of the fact that the depth of focus of the electron flux leaving imaging system 24 is generally quite large (*e.g.* of the order of 1 meter). Consequently, various other types of analysis apparatus can be used downstream of screen 26, such as:

- TEM camera 30. At camera 30, the electron flux can form a static image or diffractogram that can be processed by controller/processor 20 and displayed on a display device (not depicted), such as a flat panel display, for example. When not required, camera 30 can be retracted/withdrawn (as schematically indicated by arrows 30') so as to get it out of the way of axis B'.
- STEM camera 32. An output from camera 32 can be recorded as a function of (X,Y) scanning position of the beam B on the specimen S, and an image can be constructed that is a "map" of output from camera 32 as a function of X,Y. Camera 32 can comprise a single pixel with a diameter of *e.g.* 20 mm, as opposed to the matrix of pixels characteristically present in camera 30. Moreover, camera 32 will generally have a much higher acquisition rate (*e.g.* $10^6$ points per second) than camera 30 (*e.g.* $10^2$ images per second). Once again, when not required, camera 32 can be retracted/withdrawn (as schematically indicated by arrows 32') so as to get it out of the way of axis B' (although such retraction would not be a necessity in the case of a donut-shaped annular dark field camera 32, for example; in such a camera, a central hole would allow flux passage when the camera was not in use).
- As an alternative to imaging using cameras 30 or 32, one can also invoke spectroscopic apparatus 34, which could be an EELS module, for example.

It should be noted that the order/location of items 30, 32 and 34 is not strict, and many possible variations are conceivable. For example, spectroscopic apparatus 34 can also be integrated into the imaging system 24.

Note that controller (computer processor) 20 is connected to various illustrated components *via* control lines (buses) 20'. This controller 20 can provide a variety of functions, such as synchronizing actions, providing setpoints, processing signals, performing calculations, and displaying messages/information on a display device (not depicted). Needless to say, the (schematically depicted) controller 20 may be (partially) inside or outside the cabinet 2, and may have a unitary or composite structure, as desired.

The skilled artisan will understand that the interior of the enclosure V does not have to be kept at a strict vacuum; for example, in a so-called "Environmental TEM/STEM", a background atmosphere of a given gas is deliberately introduced / maintained within the enclosure V.

The microscope M can comprise one or more aberration correctors 40, each of which comprises a multipole lens assembly that is configured to mitigate spherical (Cs) and/or chromatic (Cc) aberration. For example, the depicted corrector 40 in the illumination system 6 might be a Cs corrector, whereas the corrector 40 in the imaging system 24 might be a combined Cs-Cc corrector (see above).

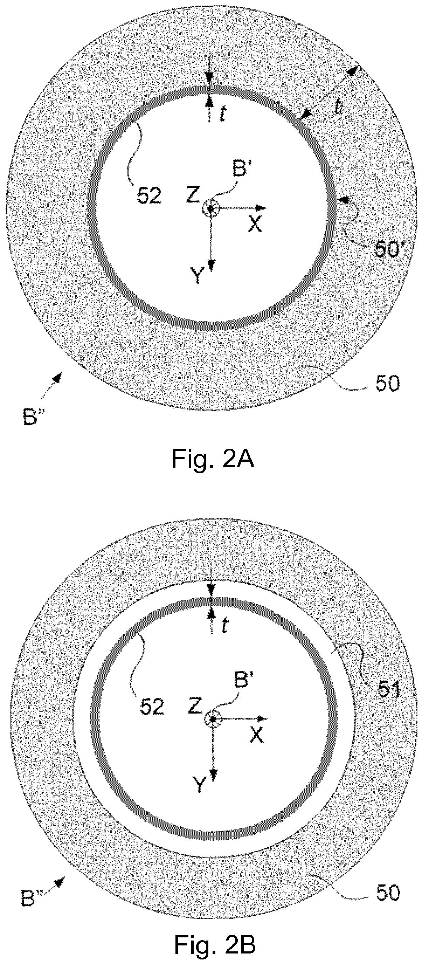

Traditionally, beam conduit B" comprises a metallic pipe. However, in the context of the present invention, this basic structure has been modified over at least part of the length (along the Z axis) of the beam conduit B". With reference to Figure 2A, which shows a magnified transverse cross-sectional view of part of the beam conduit B" of Figure 1, it is seen that, according to the invention, at least a (longitudinal) portion of beam conduit B" has a composite form comprising:

- An outer tube 50 of electrically insulating material (of wall thickness $t_t$);
- An inner skin 52 of electrically conductive material (of thickness $t$).

The outer tube 50 - with an annular cross-section - has, for example, an outer diameter of *ca.* 5-10 mm and an inner diameter of ca. 4.5-9 mm, and is, for example, comprised of ceramic or vitreous material. On its inner (cylindrical) surface 50', the skin 52 has been provided/deposited, *e.g.* with a thickness $t$ of ~15 $\mu$m, and comprising a material such as TiN. During use, the inner skin 52 is connected to electrical ground/earth. This composite structure may be used in the entire beam conduit B", but it may also be applied at just select locations thereof, such as within the correctors 40 and between each corrector 40 and the specimen S. As set forth above, such a structure shields the beam B from Johnson-Nyquist magnetic fields, and thus reduces the blurring effect of such fields.

Figure 2B shows a modified version of the situation in Figure 2A, in which an empty gap 51 exists between outer tube 50 and inner skin 52. In use, the gap 51 is evacuated to (substantially) the same vacuum level as the interior space of skin 52, so that there is (substantially) no radial pressure differential across the skin 52; conversely, if the interior of skin 52 is at a non-vacuum pressure (*e.g.* during manufacture, transport, maintenance, *etc.*), gap 51 is also held at (substantially) this same pressure. In this way, skin 52 can effectively be self-supporting, despite being relatively thin - although it is, of course, possible to provide one or more interconnections between items 52 and 50, *e.g.* in the form of radial struts, or connected extremities, for instance; it can thus also be described as a sleeve or hose, for example. The illustrated structure also applies/exploits the insights of the current invention if skin 52 has a relatively small value of $\sigma t$, *e.g.* $\sigma t < 0.1$ or $< 0.01$, for instance.

Note that the skin 52 in both of Figures 2A and 2B is "discrete" in that it is:

- Compositionally different to insulating outer tube 50; and/or;
- Physically separated from insulating outer tube 50 in the case of Figure 2B.

Embodiment 2

A composite beam conduit structure according to the invention and such as that illustrated in Figure 2A can be manufactured in various ways. For example:

- One can start with a flat sheet of green ceramic material, such as LTCC. This will ultimately become the outer tube 50 (after rolling into a cylindrical shape).
- A conductive (but highly resistive) film is deposited on a flat face of this sheet, e.g. using one of the abovementioned techniques PE-CVD, PE-ALD or PVD. This will ultimately become the skin 52.
- The sheet is now rolled into a cylinder, with the conductive film on the inside surface;

this may be done with the aid of a suitable jig/form. It is then iso-statically pressed and sintered/baked.

In an alternative approach, tube 50 is pre-formed (*e.g.* cast or rolled) in a cylindrical shape, and skin 52 is then deposited on its inside surface.

Embodiment 3

A condensed mathematical treatise will now be given of certain aspects of the invention. Electrical conductors (both magnetic and non-magnetic) produce a substantial fluctuating magnetic field at low frequencies, *via* the same thermal currents that cause the well-known Johnson-Nyquist noise in resistors. Consider a non-magnetic tube with inner radius $\alpha$, wall thickness $t \ll \alpha$, and electrical conductivity $\sigma$. One threshold frequency is related to the skin effect, and is given by:

$$\nu_{\text{skin}} = \left(\pi \mu_0 \sigma t^2\right)^{-1} . \qquad (3.1)$$

Here, $\mu_0$ is the permeability of vacuum. Consider now a loop current in a large plate of thickness $t$, with average radius $\alpha \gg t$ and DC resistance $R_0 = 2\pi/(\sigma t)$, whereby the fluctuating magnetic field is measured at a distance $\alpha$ from the plate. A reasonable approximation for the frequency-dependent resistance $R$ in this case is:

$$R(\nu) \approx \frac{2\pi}{\sigma} \left( t^{-4} + [\pi\mu_0\sigma\nu]^2 \right)^{1/4} . \qquad (3.2)$$

Current fluctuations are given by:

$$\langle I^2 \rangle = \int_0^\infty \mathrm{d}\nu \, \langle \tilde{I}^2 \rangle \qquad (3.3)$$

with:

$$\langle \tilde{I}^2 \rangle = \frac{4kTR(\nu)}{R(\nu)^2 + (2\pi L_{\mathrm{ind}}\nu)^2} \approx \frac{4kTR(\nu)}{R(\nu)^2 + (2\pi\mu_0 a\nu)^2} , \qquad (3.4)$$

in which self-inductance $L_{\mathrm{ind}} \approx \mu_0\alpha$, $k$ is the Boltzmann constant and $T$ is temperature. Hence there is a second threshold frequency $\nu_{\mathbf{ind}}$, which satisfies:

$$R(\nu_{\mathrm{ind}}) = 2\pi\mu_0 a \, \nu_{\mathrm{ind}}$$

with:

$$\nu_{\mathrm{ind}} = (\mu_0 a\sigma t)^{-1} , \qquad (3.5)$$

for $t \ll \alpha$.

Equations for the low frequency variation of the magnetic field are of the form:

$$\langle \tilde{B}^2 \rangle = \frac{C_{\mathrm{geo}}\mu_0^2 kT\sigma t}{a^2} , \qquad (3.6)$$

with geometric factor $C_{\mathrm{geo}} <\approx 0.2$. For a tube, $\alpha$ = tube radius. This can be extended to the spectral density:

$$\langle \tilde{B}^2 \rangle = \frac{C_{\mathrm{geo}}\mu_0^2 kT \sigma t}{a^2} \frac{R_0 R(\nu)}{R(\nu)^2 + (2\pi\mu_0 a\nu)^2} . \qquad (3.7)$$

Because $t \ll \alpha$, equation (3.7) can be approximated by:

$$\langle \tilde{B}^2 \rangle = \frac{C_{\mathrm{geo}}\mu_0^2 kT \sigma t}{a^2} \frac{R_0^2}{R_0^2 + (2\pi\mu_0 a\nu)^2} = \frac{C_{\mathrm{geo}}\mu_0^2 kT \sigma t}{a^2} \frac{1}{1 + (\mu_0 a\sigma t\nu)^2} , \qquad (3.8)$$

which integrates to:

$$\langle B^2 \rangle = \int_0^\infty \mathrm{d}\nu \, \langle \tilde{B}^2 \rangle = \frac{\pi C_{\mathrm{geo}}\mu_0 kT}{2a^3} . \qquad (3.9)$$

Hence, wall thickness $t$ and conductivity $\sigma$ drop out of the equation. If $\sigma t$ is reduced, the spectral density at low frequencies is reduced, but all the noise power is transferred to higher frequencies.

In order to calculate deflection angles induced by fluctuating magnetic fields, one needs to know the so-called correlation distance $\xi$ (along the tube axis) of the lateral magnetic field. One can use $\xi = 3o/2$ for fields that are generated *via* Johnson-Nyquist currents. In a so-called 'frozen dipole' scenario, assuming frequencies well below $v/2\xi$, where $v$ is the electron speed, one obtains:

$$\langle \theta^2 \rangle = \frac{\eta^2 L}{U_r} \langle B^2 \rangle \int_{-\infty}^{\infty} \mathrm{d}z \, A_n(z) = \frac{\eta^2 L}{U_r} \langle B^2 \rangle \, \xi = \frac{3\pi C_{\mathrm{geo}}}{4} \frac{\eta^2 L \, \mu_0 kT}{U_r \, a^2} \qquad (3.10)$$

for a tube of length *L,* where:

- $U$ = accelerating voltage;
- $U_r$ = relativistic voltage = $U (1 + U e/2mc^2)$, with *e* and *m* the electron charge and mass, respectively;
- $A_n(z)$ is the normalized autocorrelation function for $B(z)$, *i.e.* $A_n(0) = 1$. Possible autocorrelation functions are:

$$A_n(z) = e^{-2|z|/\xi} \qquad (3.11)$$

and

$$A_n(z) = e^{-\pi z^2/\xi^2} \, . \qquad (3.12)$$

The latter equation will be assumed hereunder.

3.1: *'Unfrozen dipoles'*

For frequencies larger than the aforementioned 'frozen dipole' threshold $v/2\xi$, electrons wiggle a number of periods while traversing the correlation distance $\xi$. This strongly reduces the net deflection angle as compared to the 'frozen dipole' case, which (partly) explains why black body radiation does not contribute significantly to image spread in a TEM. In order to include these frequencies for Johnson-Nyquist currents, use is made of a simple model with an arbitrarily large set of discrete frequencies for the lateral magnetic field on the optical axis, without any mutual correlation between the different frequencies. An axial electron is still assumed to be governed by the Lorentz force, *via*:

$$\gamma_r m \frac{\mathrm{d}^2 \vec{r}}{\mathrm{d}t^2} = -e \, \vec{v} \times \vec{B}(z,t) \, . \qquad (3.1.1)$$

Here, $\gamma_r = 1 + U e/mc^2$. The correlation function for the magnetic field is allowed to vary with frequency, *i.e.* $A_n(z)$ and $\xi$ are assumed to be frequency-dependent. One can then show for deflection angle $\theta$ that:

$$\langle \theta^2 \rangle = \frac{\eta^2 L}{U_r} \int_0^{\infty} \mathrm{d}\nu \, \langle \tilde{B}^2(\nu) \rangle \int_{-\infty}^{\infty} \mathrm{d}z \, e^{i \, 2\pi\nu z/v} \, A_n(z;\nu) \, , \qquad (3.1.2)$$

in which $\eta = (e/2m)^{1/2}$, and the exponent factor accounts for the wiggling of the electron. Equation (3.12) then leads to:

$$\langle \theta^2 \rangle = \frac{\eta^2 L}{U_r} \int_0^{\infty} \mathrm{d}\nu \, \langle \tilde{B}^2(\nu) \rangle \cdot \xi(\nu) \, e^{-\pi[\xi(\nu) \cdot \nu/v]^2} \, . \qquad (3.1.3)$$

This equation suggests that:

$$\langle \theta^2 \rangle \approx \frac{3a}{2} \frac{\eta^2 L}{U_r} \int_0^{\nu_{\mathrm{max}}} \mathrm{d}\nu \, \langle \tilde{B}^2(\nu) \rangle \, , \qquad (3.1.4)$$

in which the upper limit roughly equals the 'frozen dipole' threshold:

$$\nu_{\mathrm{max}} \approx \frac{v}{2\xi} = \frac{v}{3a} \approx \nu_{\mathrm{cut}} \cdot \frac{v}{c} \, , \qquad (3.1.5)$$

in terms of the cut-off frequency:

$$\nu_{\text{cut}} = \frac{1.84\,c}{2\pi a}$$

and speed of light $c$ in vacuum. Using equation (3.8) this leads to:

$$\langle\theta^2\rangle \approx \frac{3C_{\text{geo}}}{2}\frac{\eta^2 L\,\mu_0 kT}{U_r\,a^2}\arctan(\mu_0 a\sigma t\nu_{\text{max}})\;, \qquad (3.1.6)$$

from which it follows that a large reduction of thermal magnetic field noise can be achieved if:

$$\sigma t \ll \frac{3}{\mu_0 v} = [0.008\;\Omega^{-1}]\cdot\frac{c}{v}\;, \qquad (3.1.7)$$

in which case equation (3.1.6) simplifies to:

$$\langle\theta^2\rangle \approx \frac{3C_{\text{geo}}\eta^2 L\,\mu_0^2\,kT\,\sigma t\,\nu_{\text{max}}}{2U_r a} \approx \frac{C_{\text{geo}}\,\eta^2 L\,\mu_0^2\,kT\,v\cdot\sigma t}{2\,U_r\,a^2}\;, \qquad (3.1.8)$$

*i.e.* image spread simply scales according to $(\sigma t)^{1/2}$ in the regime given by equation (3.1.7). For example, in the specific case of an electron microscope with $U_{\text{max}}$ = 300 kV, one obtains:

$$\sigma t \ll 4/(\mu_0\,c) = 0.011\;\Omega^{-1}\;. \qquad (3.1.9)$$

Embodiment 4

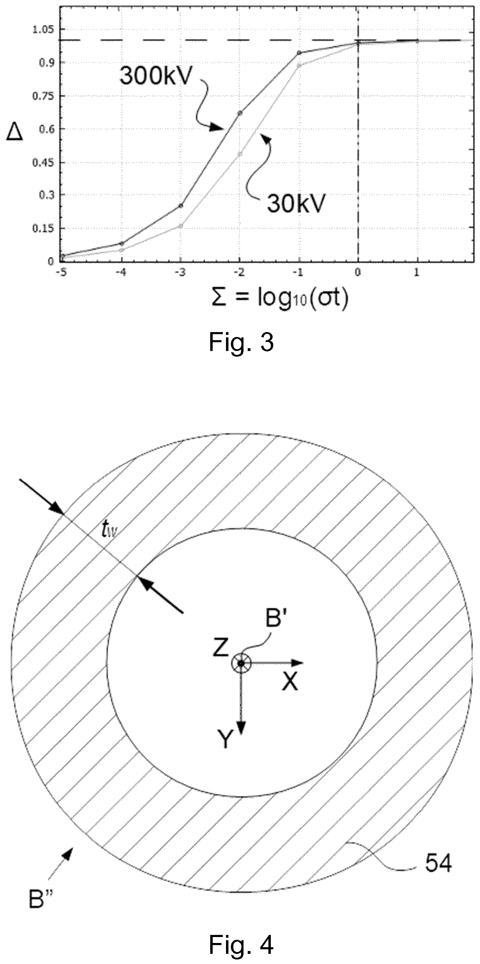

Figure 3 is a plot of relative image spread $\Delta$ (due to magnetic field noise) as a function of $\Sigma=\log_{10}(\sigma t)$ (skin conductivity x skin thickness) for an embodiment of the present invention, at beam (accelerating) voltages of 300kV (black line) and 30 kV (grey line). In essence:

$$\Delta = \theta(\sigma t)_{\text{inv}} / \theta(\sigma t)_{\text{ref}}$$

where the subscripts "inv" and "ref" respectively refer to "invention" and "reference". A conventional stainless steel beam conduit is the reference used for the vertical axis. Points below the horizontal dashed line ($\Delta = 1$) represent an improvement w.r.t. the conventional beam conduit. Note that improvement is already manifest at $\Sigma = -1$ (corresponding to $\sigma t = 0.1$), but that there is stronger improvement $\Sigma = -2$ (corresponding to $\sigma t = 0.01$), and even greater improvement at $\Sigma = -3$ (corresponding to $\sigma t = 0.001$).

Embodiment 5

Figure 4 shows a magnified transverse cross-sectional view of an alternative (but related) embodiment to that shown in Figure 2 (A and/or B). Here, the laminate composite of Figure 2 has been replaced by an aggregate composite material 54 comprising intermixed electrically insulating material and electrically conductive material, thus producing a "hybrid" material with a lower conductivity $\sigma$ than that of the skin 52 in Figure 2. The conduit B" has a wall thickness $t_w$, which is larger than the skin thickness t in Figure 2. In line with the discussion above, the product $\sigma t_w$ is relatively small, *e.g.* < 0.01 $\Omega^{-1}$, or even < 0.001 $\Omega^{-1}$.

**Claims**

1.   An Electron Microscope comprising:

- A specimen holder, for holding a specimen;
- A source, for producing a beam of electrons;
- An illumination system, for directing said beam so as to irradiate the specimen;
- An elongate beam conduit, through which the beam is directed;
- A detector, for detecting radiation emanating from the specimen in response to said irradiation,

**characterized in that** at least a longitudinal portion of said beam conduit has a composite structure comprising:

- An outer tube of electrically insulating material;
- An inner skin of electrically conductive material.

2. A microscope according to claim 1, wherein said skin has an electrical conductivity $\sigma$ and a thickness t, with $\sigma t < 0.1 \ \Omega^{-1}$, preferably $\sigma t < 0.01 \ \Omega^{-1}$.

3. A microscope according to claim 1 or 2, wherein said outer tube comprises at least one material selected from the group comprising ceramics, vitreous materials, quartz, and combinations hereof.

4. A microscope according to any of claims 1-3, wherein said inner skin comprises at least one material selected from the group comprising ruthenium oxide, titanium nitrate, and combinations hereof.

5. An Electron Microscope comprising:

- A specimen holder, for holding a specimen;
- A source, for producing a beam of electrons;
- An illumination system, for directing said beam so as to irradiate the specimen;
- An elongate beam conduit, through which the beam is directed;
- A detector, for detecting radiation emanating from the specimen in response to said irradiation,

**characterized in that** at least a longitudinal portion of said beam conduit is comprised of an aggregate composite material comprising intermixed electrically insulating material and electrically conductive material.

6. A microscope according to claim 5, wherein said beam conduit has an electrical conductivity $\sigma$ and a wall thickness $t_w$, with $\sigma t_w < 0.1 \ \Omega^{-1}$, preferably $\sigma t_w < 0.01 \ \Omega^{-1}$.

7. A microscope according to claim 5 or 6, wherein said electrically insulating material is a ceramic material.

8. A microscope according to any of claims 5-7, wherein said electrically conducting material is selected from the group comprising graphite, TiN, and mixtures hereof.

9. A microscope according to any of claims 1-8, additionally comprising:

- An imaging system, for directing electrons that are transmitted through the specimen onto said detector,

whereby said beam conduit extends through said imaging system.

10. A microscope according to any of claims 1-9, comprising a multipole lens assembly configured as an aberration corrector, wherein said longitudinal portion extends at least through said aberration corrector.

11. A microscope according to claim 10, wherein said longitudinal portion extends at least between said specimen holder and said aberration corrector.

12. A microscope according to claim 10 or 11, wherein said aberration corrector is configured to correct at least one of spherical aberration and chromatic aberration.

13. A microscope according to any of claims 1-12, wherein:

- A magnetic yoke, external to the beam conduit, is configured to conduct field lines into the direct vicinity of the beam;

- The beam conduit passes through a bore in said yoke;
- Said bore has an inner diameter that is greater than an outer diameter of the beam conduit, thus creating a gap between the two.

**14.** A method of using an Electron Microscope comprising:

- A specimen holder, for holding a specimen;
- A source, for producing a beam of electrons;
- An illumination system, for directing said beam so as to irradiate the specimen;
- A detector, for detecting radiation emanating from the specimen in response to said irradiation,

**characterized by** directing said beam through an elongate beam conduit that, at least along a portion of its length, is at least one of:

(a) A composite structure comprising:

- An outer tube of electrically insulating material;
- An inner skin of electrically conductive material.

(b) An aggregate composite material comprising intermixed electrically insulating material and electrically conductive material.

**15.** An Electron Microscope comprising:

- A specimen holder, for holding a specimen;
- A source, for producing a beam of electrons;
- An illumination system, for directing said beam so as to irradiate the specimen;
- An elongate beam conduit, through which the beam is directed, wherein at least a longitudinal portion of said beam conduit comprises a discrete inner skin of electrically conductive material;
- A detector, for detecting radiation emanating from the specimen in response to said irradiation,

**characterized in that** said inner skin has an electrical conductivity $\sigma$ and a thickness $t$, with $\sigma t < 0.1 \ \Omega^{-1}$.

EP 3 591 685 A1

Fig. 1

15

Fig. 2A

Fig. 2B

Fig. 3

Fig. 4

Europäisches
Patentamt

European
Patent Office

Office européen
des brevets

## PARTIAL EUROPEAN SEARCH REPORT

under Rule 62a and/or 63 of the European Patent Convention.
This report shall be considered, for the purposes of
subsequent proceedings, as the European search report

**Application Number**

EP 18 18 2145

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 787 696 A (DAO J ET AL) 22 January 1974 (1974-01-22) * abstract * * column 2, lines 25-64 * * column 3, line 38 - column 6, line 38; figures 1-3 * | 1,3,13, 14 | INV. H01J37/09 H01J37/26 |
| X | DE 30 10 376 A1 (SIEMENS AG [DE]) 24 September 1981 (1981-09-24) * page 1, line 13 - page 4, line 35; claims 1,3; figure * | 1,3,14 | |
| X | US 3 634 684 A (SATO MASAYUKI) 11 January 1972 (1972-01-11) * abstract * * column 1, line 3 - column 2, line 8; claim 1; figure 1 * | 1-3,14 | |
| X | JP H03 22339 A (NIKON CORP) 30 January 1991 (1991-01-30) | 1,3,13, 14 | |
| Y | * abstract * * figure * & JP 2 934707 B2 (NIKON CORP) 16 August 1999 (1999-08-16) | 10-12 | **TECHNICAL FIELDS SEARCHED (IPC)**  H01J |

-/--

## INCOMPLETE SEARCH

The Search Division considers that the present application, or one or more of its claims, does/do not comply with the EPC so that only a partial search (R.62a, 63) has been carried out.

Claims searched completely :

Claims searched incompletely :

Claims not searched :

Reason for the limitation of the search:

see sheet C

| Place of search | Date of completion of the search | Examiner |
|---|---|---|
| Munich | 8 May 2019 | Lang, Thomas |

EPO FORM 1503 03.82 (P04E07)

page 1 of 2

Europäisches
Patentamt

European
Patent Office

Office européen
des brevets

**PARTIAL EUROPEAN SEARCH REPORT**

Application Number

EP 18 18 2145

| | DOCUMENTS CONSIDERED TO BE RELEVANT | | | CLASSIFICATION OF THE APPLICATION (IPC) |
|---|---|---|---|---|
| Category | Citation of document with indication, where appropriate, of relevant passages | | Relevant to claim | |
| Y | JP 2004 241190 A (JEOL LTD) 26 August 2004 (2004-08-26) * abstract * * paragraphs [0031] - [0053]; figures 1-4 * | | 10-12 | |
| | ----- | | | |
| | | | | TECHNICAL FIELDS SEARCHED (IPC) |

EPO FORM 1503 03.82 (P04C10)

Europäisches
Patentamt

European
Patent Office

Office européen
des brevets

**INCOMPLETE SEARCH
SHEET C**

Claim(s) completely searchable:
    1-14

Claim(s) not searched:
    15

Reason for the limitation of the search:

For independent apparatus claim 5, applicant's arguments in his letter of 26.2.2019 that this claim is an alternative to claim 1 under the exception of Rule 43(2)(c) EPC may be followed prima-facie (i.e. without regard to the relevant prior art); in the sense that the insulating material of claim 1 is arranged in an alternative way (i.e. intermixed with the electrically conductive material instead of in the form of an outer tube surrounding the electrically conductive material). With regard to the prior art, however, there is non-unity within claims 1-14.
On the other hand, applicant?s arguments cannot be followed for independent claim 15. Apart from using the term "discrete inner skin" (in claim 15) instead of the term "inner skin" (in claim 1), which is however not necessarily synonymous since "discrete", although a relative expression, is not technically meaningless, claim 15 encompasses essentially the subject-matter of claim 1 but without the presence of any insulating material. It thus does not correspond to an alternative solution of a particular problem in the sense of Rule 43(2)(c) EPC, but to a more general solution of the same problem as solved by claim 1, and manifestly violates the requirement of conciseness (Art. 84 in combination with Rule 43(2) EPC). Further, although claim 15 contains the same feature as claim 2, it requires another, much broader, search than claim 2 (which depends on claim 1) due to said absence of an "insulating material" in claim 15, and thus cannot be searched fully together with claim 2.

Europäisches
Patentamt

European
Patent Office

Office européen
des brevets

Application Number

EP 18 18 2145

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

1-3, 10-13(completely); 14(partially)

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

The Search Division considers that the present European patent application does not comply with the requirements of unity of invention and relates to several inventions or groups of inventions, namely:

1. claims: 1-3, 13(completely); 14(partially)

    An Electron Microscope comprising:
    - A specimen holder, for holding a specimen;
    - A source, for producing a beam of electrons;
    - An illumination system, for directing said beam so as to irradiate the specimen;
    - An elongate beam conduit, through which the beam is directed;
    - A detector, for detecting radiation emanating from the specimen in response to said irradiation,
    wherein at least a longitudinal portion of said beam conduit has a composite structure comprising:
    - An outer tube of electrically insulating material;
    - An inner skin of electrically conductive material (claim 1);
    wherein said skin has an electrical conductivity sigma and a thickness t, with sigma t < 0.1 1/Ohm, preferably sigma t < 0.01 1/Ohm (claim 2).
    ---

2. claim: 4

    A microscope according claims 1, wherein said inner skin comprises at least one material selected from the group comprising ruthenium oxide, titanium nitrate, and combinations hereof.
    ---

3. claims: 5-8(completely); 14(partially)

    An Electron Microscope comprising:
    - A specimen holder, for holding a specimen;
    - A source, for producing a beam of electrons;
    - An illumination system, for directing said beam so as to irradiate the specimen;
    - An elongate beam conduit, through which the beam is directed;
    - A detector, for detecting radiation emanating from the specimen in response to said irradiation,
    wherein at least a longitudinal portion of said beam conduit is comprised of an aggregate composite material comprising intermixed electrically insulating material and electrically conductive material; or
    A method of using an Electron Microscope comprising:
    - A specimen holder, for holding a specimen;
    - A source, for producing a beam of electrons;
    - An illumination system, for directing said beam so as to irradiate the specimen;
    - A detector, for detecting radiation emanating from the specimen in response to said irradiation,

Europäisches
Patentamt
European
Patent Office
Office européen
des brevets

**LACK OF UNITY OF INVENTION
SHEET B**

Application Number

EP 18 18 2145

The Search Division considers that the present European patent application does not comply with the requirements of unity of invention and relates to several inventions or groups of inventions, namely:

the method comprising directing said beam through an elongate beam conduit that, at least along a portion of its length, is
(b) An aggregate composite material comprising intermixed electrically insulating material and electrically conductive material (claim 14, alternative b).

---

4. claim: 9

A microscope according to claim 1, additionally comprising:
- An imaging system, for directing electrons that are transmitted through the specimen onto said detector, whereby said beam conduit extends through said imaging system.

---

5. claims: 10-12

A microscope according to claim 1, comprising a multipole lens assembly configured as an aberration corrector, wherein said longitudinal portion extends at least through said aberration corrector.

---

**EP 3 591 685 A1**

## ANNEX TO THE EUROPEAN SEARCH REPORT
## ON EUROPEAN PATENT APPLICATION NO.

EP 18 18 2145

08-05-2019

| Patent document cited in search report | | Publication date | Patent family member(s) | | Publication date |
|---|---|---|---|---|---|
| US 3787696 | A | 22-01-1974 | NONE | | |
| DE 3010376 | A1 | 24-09-1981 | NONE | | |
| US 3634684 | A | 11-01-1972 | DE | 2012431 A1 | 24-09-1970 |
| | | | FR | 2034981 A1 | 18-12-1970 |
| | | | GB | 1308971 A | 07-03-1973 |
| | | | US | 3634684 A | 11-01-1972 |
| JP H0322339 | A | 30-01-1991 | JP | 2934707 B2 | 16-08-1999 |
| | | | JP | H0322339 A | 30-01-1991 |
| JP 2004241190 | A | 26-08-2004 | NONE | | |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5084622 A

### Non-patent literature cited in the description

- **S. UHLEMANN et al.** Physical Review Letters [PRL. American Physical Society, 26 July 2013, vol. 111, 046101-046105
- **I.S. BELOBORODOV et al.** Granular electronic systems. *Rev. Mod. Phys.,* April 2007, vol. 79, 469, https://journals.aps.org/rmp/abstract/10.1103/RevModPhys.79.469
- **H. ROSE ; W. WAN.** Aberration correction in electron microscopy. *IEEE Proceedings of 2005 Particle Accelerator Conference,* 2005, 44-48